# EUROPEAN PATENT SPECIFICATION

(11) **EP 3 927 125 B1**
(45) Date of publication and mention of the grant of the patent: **03.04.2024**
(21) Application number: 20180889.6
(22) Date of filing: 18.06.2020
(51) Int. Cl.: H05K 5/00

(54) **CONTROL UNIT AND ELECTRIC HEATING DEVICE**
STEUEREINHEIT UND ELEKTRISCHE HEIZVORRICHTUNG
UNITÉ DE COMMANDE ET DISPOSITIF DE CHAUFFAGE ÉLECTRIQUE

(43) Date of publication of application: 22.12.2021
(73) Proprietor: Mahle International GmbH, 70376 Stuttgart (DE)
(72) Inventor: DAUDON, Guillaume, 88470 La Bourgonce (FR); EDEL, Nicolas, 68360 Soultz (FR); FEUGERE, Jacques, 68360 Soultz (FR); STOECKEL, Jérôme, 68540 Bollwiller (FR)
(74) Representative: BRP Renaud & Partner mbB Rechtsanwälte Patentanwälte Steuerberater

(56) References cited:
- EP-A1- 3 480 532
- EP-A1- 3 544 121
- WO-A1-2019/138173
- FR-A1- 3 075 327
- US-A1- 2013 062 337

## Description

The invention relates to a control unit for an electric heating device and to an electric heating device having such a control unit.

For the controlled generation of heat, electric heating devices for motor vehicles have been equipped with control units for some time. In so doing, a high-voltage line of the control unit is usually electrically connected to an electric power device by means of which electric energy fed to the electric power device via the high-voltage line can be converted into heat. At the end of the electrical high-voltage line of the control unit located opposite the electric power device an electrical high-voltage power source is electrically connected to the high-voltage line via a high-voltage interface. By means of the control unit, the electric power fed to the power device via the high-voltage line and thus a heating output of the power device can be varied in a controlled manner. The control of the current fed to the electric power device is typically effected by means of the control unit as a function of a control signal, which can be fed to the control unit via a low-voltage interface provided on the control unit.

Here it has proved to be disadvantageous that the high-voltage and the low-voltage interface, depending on the specification of the high-voltage power source or a signal source generating the control signal, require a very different configuration. With conventional control units for electric heating devices, this has the consequence that such control units have to be altogether differently designed and produced for different specifications of the high-voltage power source or of the signal source. Apart from this, control electronics of the control unit, in conventional control units, are typically embedded within a housing interior of a control unit housing for fixing the control electronics with a casting compound, which renders accessibility of the control electronics for maintenance purposes substantially more difficult or even impossible.

It is therefore an object of the present invention - in particular for eliminating the disadvantages mentioned above - to show new ways for control units for electric heating devices and for electric heating devices having such a control unit which address in particular the above mentioned disadvantage.

Document EP3480532 describes an electric heating device according to the preamble portion of claim 1. Further prior art US2013/062337 describes a vehicle air conditioning apparatus provided with a heat medium heating device.

Accordingly, the basic idea of the invention is to equip a control unit for an electric heating device with at least two housing parts which jointly bound a housing interior, in which control electronics of the control unit are arranged. There, a high-voltage and a low-voltage interface of the control unit are merely arranged on one of the housing parts. Control electronics of the control unit arranged in the housing interior are electrically connected to the high-voltage and the low-voltage interface by means of press fit elements in each case.

Merely the housing part comprising the interfaces and its interface configuration can thus be advantageously adapted to different specifications of the high-voltage power source or the signal source in a structurally simple yet cost-efficient manner. The remaining components can be substantially maintained unchanged for all specifications of the high-voltage power source or of the signal source. Apart from this, accessibility to the control electronics for maintenance purposes can also be significantly improved by electrically connecting the control electronics to the interfaces by means of the press fit elements.

The invention is defined by the independent claim 1.

Preferred embodiments are defined by the dependent claims.

A control unit according to the invention can be employed for an electric heating device, in particular for a motor vehicle. The control unit comprises a first and at least one second housing part which each jointly bound a housing interior on the inside. Here, the housing parts separate the housing interior, preferentially in a dust and liquid-tight manner, from an external environment of the control unit. In addition, the control unit comprises a low-voltage and a high-voltage interface which are arranged on the first housing part on the outside. Furthermore, the control unit comprises control electronics which are received in the housing interior and which, by means of an electrical low-voltage line, are electrically connected to the low-voltage interface and by means of an electrical high-voltage line, electrically connected to the high-voltage interface. Here, the low-voltage and - alternatively or additionally - the high-voltage line at its line end arranged in the housing interior comprise(s) at least one first press fit element, which, electrically connecting the control electronics to the respective interface - forms a press fit with a second press fit element present on the control electronics for this purpose. As already indicated above, it is thus advantageously achieved that for different specifications of the high-voltage power source or of the signal source merely the housing part comprising the interfaces and its interface configuration have to be adapted in a structurally simple yet cost-effective manner, which brings about cost advantages. Apart from this, fastening the control electronics by means of the press fit renders encapsulating the control electronics in the housing interior obsolete.

According to an advantageous further development of the control unit according to the invention, the first housing part comprises material-uniformly an interface wall and a carrier section. Here, the first housing part with its interface wall bounds the housing interior on the inside, wherein the carrier section projects from the interface wall on the inside and into the housing interior. The high-voltage and the low-voltage interface are arranged on the interface wall. The first press fit element of the low-voltage and - alternatively or additionally - the high-voltage line are arranged on the carrier section. This allows a particularly installation-space-saving realisation of the control unit.

In a further preferred further development of the control unit, the first housing part bounds the housing interior by means of the interface wall, jointly with the second housing part, in a dust and liquid-tight manner. By way of this, the control electronics can be protected from environmental influences which threaten the functioning of the control electronics and in the worst case can result in a failure of the control electronics.

In a further advantageous further development of the control unit it is provided that between the first and the second housing part a seal is present. Advantageously, the control electronics can thus be particularly effectively protected from environmental influences.

According to a further preferred further development of the control unit, the seal is arranged between a circumference of the interface wall and the second housing part, wherein on the circumference preferentially a circumferential groove is recessed, in which the seal is partially received. This advantageously ensures a reliable seating of the seal.

Another advantageous further development of the control unit provides that the low-voltage line comprises a low-voltage bus-bar. Said low-voltage bus-bar is embedded in regions in a material of the first housing part, preferentially overmolded with the material of the first housing part. Separate fastening means for fastening the low-voltage line or its low-voltage bus-bar on the first housing part can consequently be dispensed with.

In a further preferred development of the control unit, the first press fit element of the low-voltage line is present on the low-voltage bus-bar. Advantageously, the low-voltage bus-bar offers adequate mechanical stiffness so that it can mechanically withstand the mechanical load developing while the press fit is created by means of the first and second press fit elements.

According to a further preferred further development of the control unit, the low-voltage line, at least in a passage region of the same, in which the low-voltage line passes through the first housing part from the outside to the inside, comprises the low-voltage bus-bar. This allows realising a particularly compact structure of the control unit.

According to the invention, the high-voltage line comprises a high-voltage bus-bar. Said high-voltage bus-bar is embedded in a material of the first housing part in certain regions, preferentially overmolded with the material of the first housing part. Separate fastening means for fastening the high-voltage line or its high-voltage bus-bar on the first housing part can consequently be dispensed with.

In a further advantageous further development of the control unit, the first press fit element of the high-voltage line is present on the high-voltage bus-bar. The high-voltage bus-bar advantageously offers adequate mechanical stiffness so that it can easily mechanically withstand the mechanical load developing while the press fit is created by means of the first and second press fit elements.

According to the invention, the high-voltage line comprises a high-voltage cable, at least in a passage region of the same, in which the high-voltage line passes through the first housing part from the outside to the inside. Such a high-voltage cable can advantageously transmit major electric power.

Practically, the high-voltage cable is electrically connected to the high-voltage bus-bar in the housing interior in an integrally bonded manner, in particular soldered. This offers a particularly cost-effective possibility of producing the high-voltage line and thus also the entire control unit.

A further advantageous further development of the control unit provides that on the high-voltage interface an electromagnetic shield is present, which is electrically connected to an electrical grounding present on the first housing part.

Consequently, any electromagnetic fields spontaneously developing during the coupling of the electrical high-voltage power source to the high-voltage interface can be effectively kept away from the surroundings of the control unit and devices that are present in these surroundings, which is advantageous with respect to the electromagnetic compatibility of the control unit.

According to a further preferred further development of the control unit, an interlocking device is arranged on the high-voltage interface by means of which a high-voltage power source can be electrically coupled to the high-voltage interface in a detachable manner. This ensures a reliable coupling of the high-voltage power source on the control unit.

In addition, the invention relates to an electric heating device, in particular for a motor vehicle. The electric heating device comprises a control unit according to the invention as described above. Furthermore, the electric heating device comprises an electric power device which, for the controlled generation of heat, is connected to the high-voltage line of the control unit via the high-voltage interface. The advantages of the control unit according to the invention shown above apply analogously also to the heating device according to the invention having such a control unit.

Further important features and advantages of the invention are obtained from the subclaims, from the drawings and from the associated figure description by way of the drawings.

Preferred exemplary embodiments of the invention are shown in the drawings and are explained in more detail in the following description, wherein same reference numbers relate to same or similar or functionally same components.

It shows, in each case schematically:
- Fig. 1: an example of a control unit according to the invention in a perspective representation,
- Fig. 2: in a perspective representation, the control unit of Figure 1 with a removed second housing part of the control unit,
- Fig. 3 to 5: different perspective details of the control unit of Figures 1 and 2.

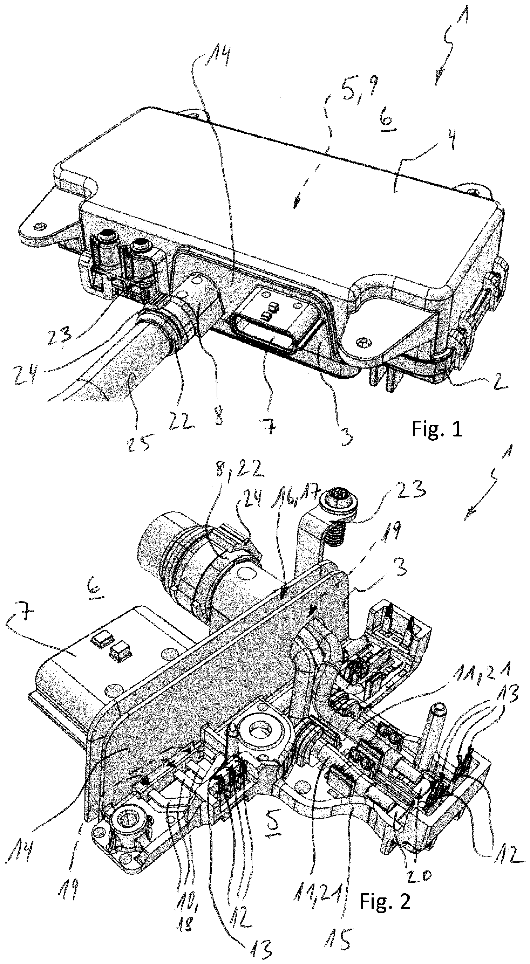

In Figure 1, a control unit 1 according to the invention is exemplarily shown, which can be part of an electric heating device according to the invention that is not shown in more detail in the figures. Such a heating device with the control unit can be part of a motor vehicle. The heating device comprises an electric power device, which for the controlled generation of heat, is connected to a high-voltage line 11 of the control unit via a high-voltage interface 8, which electric power device however is likewise not shown in the figures.

In the example of Figure 1, the control unit comprises one first housing part 3 and two second housing parts 2, 4. The first and the second housing parts 3, 2, 4 each jointly bound a housing interior 5 on the inside. Here, the housing parts 3, 2, 4 separate the housing interior 5 from an external environment 6 of the control unit 1. By means of the housing parts 3, 2, 4, the housing interior 5 can be separated from the external environment 6 in a dust and liquid-tight manner. On the first housing part 3 outside, a low-voltage interface 7 of the control unit 1 is arranged. Apart from this, the high-voltage interface 8 of the control unit 1 is arranged on the first housing part 3 outside. The control unit 1, furthermore, comprises control electronics 9 which are received in the housing interior 5 and which are not shown in more detail in the figures.

Figure 2 shows the control unit of Figure 1 in a perspective representation, wherein for better clarity the second housing parts 2, 4 and the control electronics 9 are hidden. The control electronics 9 that are not shown are electrically connected to the low-voltage interface 7 by means of a low-voltage line 10 that is noticeable in Figure 2. Apart from this, the control electronics 9 are electrically connected to the high-voltage interface 8 by means of the high-voltage line 11. The low-voltage line 10 and - alternatively or additionally - the high-voltage line 11 comprise/comprises at its line end(s) 12 arranged in the housing interior, at least one first press fit element 13. This first press fit element 13, electrically connecting the control electronics 9 to the relevant interface 7, 8, forms a press fit with a second press fit element that is present on the control electronics 9 - but which is not shown in the figures. In the shown example, the high-voltage line 11 and the low-voltage line 10 are each equipped with multiple such first press fit elements 13. The first press fit elements 13 and the second press fit elements that are not shown can be matched to one another so that the first press fit elements 13 can be received in receptacles of the second press fit elements, or vice versa.

Figure 2 shows, furthermore, that the first housing part 3 comprises a material-uniform interface wall 14 and a carrier section 15. With its interface wall 14, the first housing part 3 bounds the housing interior 5 on the inside. On the inside, the carrier section 15 projects from the interface wall 14 so that the carrier section 15 projects into the housing interior 15. Here, the high-voltage and the low-voltage interface 7, 8 are arranged on the interface wall 14, while the first press fit elements 13 of the low-voltage and of the high-voltage line 10, 11 are arranged on the carrier section 15.

As illustrated in Figure 1, the first housing part 3, by means of its interface wall 14 jointly with the second housing parts 2, 4, bounds the housing interior 5 in a dust and liquid-tight manner. Here, a seal is present between the first and the second housing parts 3, 2, 4. The seal is arranged between a circumference 16 of the interface wall 14 and the second housing parts 2, 4.

On the circumference 16 of the interface wall 14, a circumferential groove 17 can be recessed as is noticeable in Figure 2. The seal can be or is partly received in the groove 17.

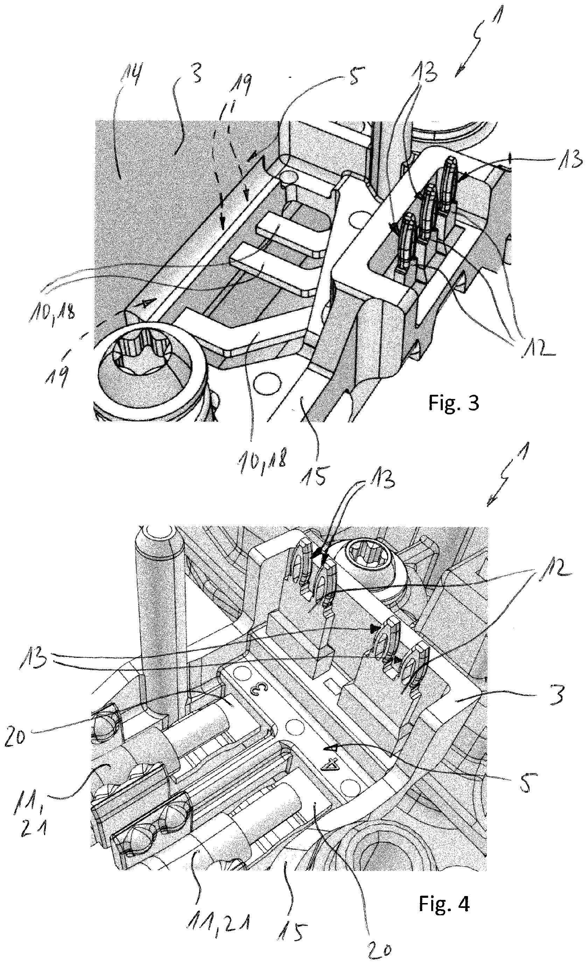

Figure 3 illustrates a perspective detail representation of the control unit 1 of the Figures 1 and 2. It is noticeable that the low-voltage line 10 comprises a low-voltage bus-bar 18. The low-voltage bus-bar 18 is embedded in regions in a material of the first housing part 3. In the shown example, the low-voltage bus-bar 18 is overmolded with the material of the first housing part 3. Here, the first press fit element 13 of the low-voltage line 10 is present on the low-voltage bus-bar 18 of the same. The low-voltage line 10 comprises a passage region 19, in which it passes through the first housing 3 from the outside to the inside. At least in this passage region 19, the low-voltage line 10 comprises the low-voltage bus-bar 18 or is formed in the passage region 19 as low-voltage bus-bar 18.

In Figure 4, a further perspective detail representation of the control unit of the Figures 1 to 3 is shown. Accordingly, the high-voltage line 11 comprises a high-voltage bus-bar 20. The high-voltage bus-bar 20 is embedded in regions in the material of the first housing part 3. In the shown example, the high-voltage bus-bar 20 is overmolded with the material of the first housing part 3. Here, the first press fit element 13 of the high-voltage line 11 is present on the high-voltage bus-bar 20 of the same.

Figure 2, furthermore, shows that the high-voltage line 11 has a passage region in which the high-voltage line 11 passes through the first housing part 3 from the outside to the inside. In this passage region 19 of the high-voltage line 11, the high-voltage line 11 comprises a high-voltage cable 21 or is formed as high-voltage cable 21. In the housing interior 5, the high-voltage cable 21 is electrically connected in an integrally bonded manner to the high-voltage bus-bar 20. For example, the high-voltage cable 21 is soldered to the high-voltage bus-bar 20.

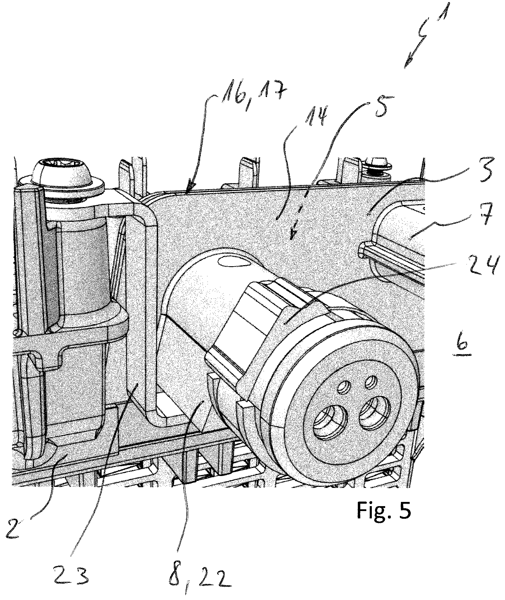

In Figure 5, a further perspective detail view of the control unit of the Figures 1 to 4 is shown. Accordingly, an electromagnetic shield 22 is present on the high-voltage interface 8. This electromagnetic shield 22 is electrically connected to an electrical grounding 23 that is present on the first housing part 3. On the high-voltage interface 8, an interlocking device 24 is arranged, furthermore, by means of which a high-voltage power source 25 (see Figure 1) can be detachably electrically coupled to the high-voltage interface 8.

## Claims

1. A control unit (1) for an electric heating device, in particular for a motor vehicle,
- having a first and at least one second housing part (3, 2, 4), each of which jointly bound a housing interior (5) on the inside and which separate the housing interior (5), preferentially in a dust and liquid-tight manner, from an external environment (6) of the control unit (1),
- having a low-voltage and high-voltage interface (7, 8) each of which being arranged on the first housing part (3) on the outside,
- having control electronics (9) which are received in the housing interior (5) and which are electrically connected to the low-voltage interface (7) by via an electrical low-voltage line (10) and to the high-voltage interface (8) by via an electrical high-voltage line (11),
- wherein the low-voltage and/or the high-voltage line (10, 11) at their line end (12) arranged in the housing interior (5) comprises at least one first press fit element (13), which, electrically connecting the control electronics (9) to the relevant interface (7, 8), forms a press fit with a second press fit element present on the control electronics (9),
- wherein the high-voltage line (11) comprises a high-voltage bus-bar (20),
- wherein the high-voltage bus-bar (20) in regions is embedded in a material of the first housing part (3), preferentially overmolded with the material of the first housing part (3),
**characterized in that**
- the high-voltage line (11), at least in a passage region (19), in which the high-voltage line (11) passes through the first housing part (3) from the outside to the inside, comprises a high-voltage cable (21); and that
- the high-voltage cable (21) is electrically connected to the high-voltage bus-bar (20) in the housing interior (5) in an integrally bonded manner, in particular soldered.

2. The control unit (1) according to claim 1,
**characterized in that**
- the first housing part (3) material-uniformly comprises an interface wall (14) and a carrier section (15),
- wherein the first housing part (3) with its interface wall (14) bounds the housing interior (5) on the inside and the carrier section (15) projects from the interface wall (14) on the inside and reaches into the housing interior (5),
- wherein the high-voltage and the low-voltage interface (7, 8) are arranged on the interface wall (14),
- wherein the first press fit element (13) of the low-voltage and/or of the high-voltage line (10, 11) are/is arranged on the carrier section (15).

3. The control unit (1) according to Claim 2,
**characterized in that**
the first housing part (3), by means of its interface wall (14), jointly with the second housing part (2, 4), bounds the housing interior (5) in a dust and liquid-tight manner.

4. The control unit (1) according to any one of claims 1 to 3,
**characterized in that**
between the first and the second housing part (3, 2, 4) a seal is present.

5. The control unit (1) according to Claim 3 and 4,
**characterized in that**
the seal is arranged between a circumference (16) of the interface wall (14) and the second housing part (2, 4), wherein on the circumference (16) preferentially a circumferential groove (17) is recessed, in which the seal is partly received.

6. The control unit (1) according to any one of the preceding claims,
**characterized in that**
- the low-voltage line (10) comprises a low-voltage bus-bar (18),
- the low-voltage bus-bar (18) in regions is embedded in a material of the first housing part (3), preferentially overmolded with the material of the first housing part (3).

7. The control unit (1) according to Claim 6,
**characterized in that**
the first press fit element (13) of the low-voltage line (10) is present on the low-voltage bus-bar (18).

8. The control unit (1) according to Claim 6 or 7,
**characterized in that**
the low-voltage line (10) comprises the low-voltage bus-bar (18) at least in a passage region (19), in which the low-voltage line (10) passes through the first housing part (3) from the outside to the inside.

9. The control unit (1) according to any of the preceding claims,
**characterized in that**
the first press fit element (13) of the high-voltage line (11) is present on the high-voltage bus-bar (20).

10. The control unit (1) according to any one of the preceding claims,
**characterized in that**
on the high-voltage interface (8) an electromagnetic shield (22) is present, which is electrically connected to an electrical grounding (23) that is present on the first housing part (3).

11. The control unit (1) according to any one of the preceding claims,
**characterized in that**
on the high-voltage interface (8) an interlocking device (24) is arranged, by means of which a high-voltage power source (25) can be detachably coupled electrically to the high-voltage interface (8).

12. An electric heating device, in particular for a motor vehicle,
- having a control unit (1) according to any one of the preceding claims,
- having an electric power device, which for the controlled generation of heat is connected to the high-voltage line (11) of the control unit (1) via the high-voltage interface (8).

## Patentansprüche

1. Steuereinheit (1) für eine elektrische Heizvorrichtung, insbesondere für ein Kraftfahrzeug,
- die ein erstes und mindestens ein zweites Gehäuseteil (3, 2, 4) aufweist, die jeweils
einen Gehäuseinnenraum (5) gemeinsam nach innen begrenzen und den Gehäuseinnenraum (5) bevorzugt staub- und flüssigkeitsdicht von einer Außenumgebung (6) der Steuereinheit (1) trennen,
- die eine Niederspannungs- und eine Hochspannungsschnittstelle (7, 8) aufweist, die jeweils außen am ersten Gehäuseteil (3) angeordnet sind,
- die eine im Gehäuseinnenraum (5) aufgenommene Steuerelektronik (9) aufweist, die über eine elektrische Niederspannungsleitung (10) mit der Niederspannungsschnittstelle (7) und über eine elektrische Hochspannungsleitung (11) mit der Hochspannungsschnittstelle (8) elektrisch verbunden ist,
- wobei die Niederspannungs- und/oder die Hochspannungsleitung (10, 11) an ihrem im Gehäuseinnenraum (5) angeordneten Leitungsende (12) mindestens ein erstes Presssitzselement (13) umfassen, welches die Steuerelektronik (9) mit der betreffenden Schnittstelle (7, 8) elektrisch verbindet, einen Presssitz mit einem zweiten an der Steuerelektronik (9) vorhandenen Presssitzselement bildet,
- wobei die Hochspannungsleitung (11) eine Hochspannungssammelschiene (20) umfasst,
- wobei die Hochspannungssammelschiene (20) bereichsweise in ein Material des ersten Gehäuseteils (3) eingebettet, bevorzugt mit dem Material des ersten Gehäuseteils (3) umspritzt ist,
**dadurch gekennzeichnet, dass**
- die Hochspannungsleitung (11) mindestens in einem Durchgangsbereich (19), in dem die Hochspannungsleitung (11) durch das erste Gehäuseteil (3) von außen nach innen hindurchgeht, ein Hochspannungskabel (21) umfasst; und dass
- das Hochspannungskabel (21) mit der Hochspannungssammelschiene (20) im Gehäuseinneren (5) stoffschlüssig elektrisch verbunden, insbesondere verlötet ist.

2. Steuereinheit (1) nach Anspruch 1,
**dadurch gekennzeichnet, dass**
- das erste Gehäuseteil (3) materialeinheitlich eine Schnittstellenwand (14) und einen Trägerabschnitt (15) umfasst,
- wobei das erste Gehäuseteil (3) mit seiner Schnittstellenwand (14) den Gehäuseinnenraum (5) innen begrenzt und der Trägerabschnitt (15) innen von der Schnittstellenwand (14) vorsteht und in den Gehäuseinnenraum (5) hineinreicht,
- wobei die Hochspannungs- und die Niederspannungsschnittstelle (7, 8) an der Schnittstellenwand (14) angeordnet sind,
- wobei das erste Presssitzelement (13) der Niederspannungs- und/oder der Hochspannungsleitung (10, 11) am Trägerabschnitt (15) angeordnet ist/sind.

3. Steuereinheit (1) nach Anspruch 2,
**dadurch gekennzeichnet, dass**
das erste Gehäuseteil (3) mittels seiner Schnittstellenwand (14) gemeinsam mit dem zweiten Gehäuseteil (2, 4) den Gehäuseinnenraum (5) staub- und flüssigkeitsdicht begrenzt.

4. Steuereinheit (1) nach einem der Ansprüche 1 bis 3,
**dadurch gekennzeichnet, dass**
zwischen dem ersten und dem zweiten Gehäuseteil (3, 2, 4) eine Dichtung vorhanden ist.

5. Steuereinheit (1) nach Anspruch 3 und 4,
**dadurch gekennzeichnet, dass**
die Dichtung zwischen einem Umfang (16) der Schnittstellenwand (14) und dem zweiten Gehäuseteil (2, 4) angeordnet ist, wobei am Umfang (16) bevorzugt eine umlaufende Nut (17) eingelassen ist, in der die Dichtung teilweise aufgenommen ist.

6. Steuereinheit (1) nach einem der vorstehenden Ansprüche,
**dadurch gekennzeichnet, dass**
- die Niederspannungsleitung (10) eine Niederspannungssammelschiene (18) umfasst,
- die Niederspannungssammelschiene (18) bereichsweise in ein Material des ersten Gehäuseteils (3) eingebettet, bevorzugt mit dem Material des ersten Gehäuseteils (3) umspritzt ist.

7. Steuereinheit (1) nach Anspruch 6,
**dadurch gekennzeichnet, dass**
das erste Presssitzelement (13) der Niederspannungsleitung (10) an der Niederspannungssammelschiene (18) vorhanden ist.

8. Steuereinheit (1) nach Anspruch 6 oder 7,
**dadurch gekennzeichnet, dass**
die Niederspannungsleitung (10) die Niederspannungssammelschiene (18) mindestens in einem Durchgangsbereich (19) umfasst, in dem die Niederspannungsleitung (10) von außen nach innen durch das erste Gehäuseteil (3) hindurchgeht.

9. Steuereinheit (1) nach einem der vorstehenden Ansprüche,
**dadurch gekennzeichnet, dass**
das erste Presssitzelement (13) der Hochspannungsleitung (11) an der Hochspannungssammelschiene (20) vorhanden ist.

10. Steuereinheit (1) nach einem der vorstehenden Ansprüche,
**dadurch gekennzeichnet, dass**
an der Hochspannungsschnittstelle (8) eine elektromagnetische Abschirmung (22) vorhanden ist, die elektrisch mit einer am ersten Gehäuseteil (3) vorhandenen elektrischen Erdung (23) verbunden ist.

11. Steuereinheit (1) nach einem der vorstehenden Ansprüche,
**dadurch gekennzeichnet, dass**
an der Hochspannungsschnittstelle (8) eine Verriegelungseinrichtung (24) angeordnet ist, mittels derer eine Hochspannungsstromquelle (25) lösbar mit der Hochspannungsschnittstelle (8) elektrisch gekoppelt werden kann.

12. Elektrische Heizvorrichtung, insbesondere für ein Kraftfahrzeug,
- die eine Steuereinheit (1) nach einem der vorstehenden Ansprüche aufweist,
- die eine elektrische Leistungsvorrichtung aufweist, die zur gesteuerten Erzeugung von Wärme über die Hochspannungsschnittstelle (8) mit der Hochspannungsleitung (11) der Steuereinheit (1) verbunden ist.

## Revendications

1. Unité de commande (1) pour un dispositif de chauffage électrique, en particulier pour un véhicule automobile,
- présentant une première et au moins une seconde partie formant boîtier (3, 2, 4), qui
relient chacune ensemble un intérieur de boîtier (5) sur l'intérieur et qui séparent l'intérieur de boîtier (5), préférentiellement de manière étanche à la poussière et aux liquides, d'un environnement externe (6) de l'unité de commande (1),
- présentant une interface basse-tension et une interface haute-tension (7, 8), chacune étant agencée sur l'extérieur sur la première partie formant boîtier (3),
- présentant une électronique de commande (9) qui est reçue dans l'intérieur de boîtier (5) et qui est raccordée électriquement à l'interface basse-tension (7) par le biais d'une ligne électrique basse-tension (10) et à l'interface haute-tension (8) par le biais d'une ligne électrique haute-tension (11),
- dans laquelle la ligne basse-tension et/ou la ligne haute-tension (10, 11) comprennent, au niveau de leur extrémité de ligne (12) agencée dans l'intérieur de boîtier (5), au moins un premier élément d'ajustement par pression (13), qui, raccordant électriquement l'électronique de commande (9) à l'interface (7, 8) appropriée, forme un ajustement par pression avec un second élément d'ajustement par pression présent sur l'électronique de commande (9),
- dans laquelle la ligne haute-tension (11) comprend une barre omnibus haute-tension (20),
- dans laquelle la barre omnibus haute-tension (20), dans des régions, est noyée dans un matériau de la première partie formant boîtier (3), préférentiellement surmoulée avec le matériau de la première partie formant boîtier (3),
**caractérisée en ce que**
- la ligne haute-tension (11), au moins dans une région de passage (19), dans laquelle la ligne haute-tension (11) traverse la première partie formant boîtier (3) de l'extérieur vers l'intérieur, comprend un câble haute-tension (21) ; et **en ce que**
- le câble haute-tension (21) est raccordé électriquement à la barre omnibus haute-tension (20) dans l'intérieur de boîtier (5) par liaison d'un seul tenant, en particulier de manière soudée.

2. Unité de commande (1) selon la revendication 1,
**caractérisée en ce que**
- la première partie formant boîtier (3) comprend de manière matériellement uniforme une paroi d'interface (14) et une section de support (15),
- dans laquelle la première partie formant boîtier (3) avec sa paroi d'interface (14) délimite l'intérieur de boîtier (5) sur l'intérieur et la section de support (15) fait saillie depuis la paroi d'interface (14) sur l'intérieur et arrive dans l'intérieur de boîtier (5),
- dans laquelle l'interface haute-tension et l'interface basse-tension (7, 8) sont agencées sur la paroi d'interface (14),
- dans laquelle le premier élément d'ajustement par pression (13) de la ligne basse-tension et/ou de la ligne haute-tension (10, 11) est agencé/sont agencés sur la section de support (15).

3. Unité de commande (1) selon la revendication 2,
**caractérisée en ce que**
la première partie formant boîtier (3) délimite, au moyen de sa paroi d'interface (14), conjointement avec la seconde partie formant boîtier (2, 4), l'intérieur de boîtier (5) de manière étanche à la poussière et aux liquides.

4. Unité de commande (1) selon l'une quelconque des revendications 1 à 3,
**caractérisée en ce que**
entre la première et la seconde partie formant boîtier (3, 2, 4), un joint d'étanchéité est présent.

5. Unité de commande (1) selon les revendications 3 et 4,
**caractérisée en ce que**
le joint est agencé entre une circonférence (16) de la paroi d'interface (14) et la seconde partie formant boîtier (2, 4), dans laquelle, sur la circonférence (16), préférentiellement une rainure circonférentielle (17) est creusée, dans laquelle le joint est partiellement reçu.

6. Unité de commande (1) selon l'une quelconque des revendications précédentes,
**caractérisée en ce que**
- la ligne basse-tension (10) comprend une barre omnibus basse-tension (18),
- la barre omnibus basse-tension (18), dans des régions, est noyée dans un matériau de la première partie formant boîtier (3), préférentiellement surmoulée avec le matériau de la première partie formant boîtier (3).

7. Unité de commande (1) selon la revendication 6,
**caractérisée en ce que**
le premier élément d'ajustement par pression (13) de la ligne basse-tension (10) est présent sur la barre omnibus basse-tension (18).

8. Unité de commande (1) selon la revendication 6 ou 7,
**caractérisée en ce que**
la ligne basse-tension (10) comprend la barre omnibus basse-tension (18) au moins dans une région de passage (19), dans laquelle la ligne basse-tension (10) traverse la première partie formant boîtier (3) de l'extérieur vers l'intérieur.

9. Unité de commande (1) selon l'une quelconque des revendications précédentes,
**caractérisée en ce que**
le premier élément d'ajustement par pression (13) de la ligne haute-tension (11) est présent sur la barre omnibus haute-tension (20).

10. Unité de commande (1) selon l'une quelconque des revendications précédentes,
**caractérisée en ce que**
sur l'interface haute-tension (8), un blindage électromagnétique (22) est présent, qui est raccordé électriquement à une mise à la terre électrique (23) qui est présente sur la première partie formant boîtier (3).

11. Unité de commande (1) selon l'une quelconque des revendications précédentes, **caractérisée en ce que**
sur l'interface haute-tension (8), un dispositif de verrouillage (24) est agencé, au moyen duquel une source d'énergie haute-tension (25) peut être couplée électriquement de manière amovible à l'interface haute-tension (8).

12. Dispositif de chauffage électrique, en particulier pour un véhicule automobile,
- présentant une unité de commande (1) selon l'une quelconque des revendications précédentes,
- présentant un dispositif d'alimentation électrique qui, pour la production régulée de chaleur, est raccordé à la ligne haute-tension (11) de l'unité de commande (1) par le biais de l'interface haute-tension (8).
